# EUROPÄISCHE PATENTSCHRIFT

(11) **EP 0 492 255 B1**
(45) Veröffentlichungstag und Bekanntmachung des Hinweises auf die Patenterteilung: **20.09.1995**
(21) Anmeldenummer: 91121086.2
(22) Anmeldetag: 09.12.1991
(51) Int. Cl.: C08F 220/18, C08F 222/06

(54) **Mischpolymere**
Copolymers
Copolymères

(30) Priorität: 20.12.1990 DE 4041000
(43) Veröffentlichungstag der Anmeldung: 01.07.1992
(73) Patentinhaber: SIEMENS AKTIENGESELLSCHAFT, 80333 München (DE)
(72) Erfinder: Sezi, Recai, Dr., W-8551 Röttenbach (DE); Borndörfer, Horst, W-8520 Erlangen (DE); Ahne, Hellmut, Dr., W-8551 Röttenbach (DE); Birkle, Siegfried, Dr., W-8552 Höchstadt (DE); Kühn, Eberhard, W-8551 Hemhofen (DE); Leuschner, Rainer, Dr., W-8520 Erlangen (DE); Rissel, Eva, W-8550 Forchheim (DE); Sebald, Michael, Dr., W-8521 Hessdorf-Hannberg (DE)

(56) Entgegenhaltungen:
- DE-A- 1 495 850

## Beschreibung

Die Erfindung betrifft neue Mischpolymere, die als Basispolymere für hochauflösende Resists dienen können.

Hochempfindliche Resistsysteme enthalten beispielsweise Homopolymere von Acrylsäure-, Methacrylsäure- oder Vinylbenzoesäure-tert.-butylester (siehe dazu EP-A-0 102 450 bzw. die entsprechende US--A-4 491 628). Bekannt ist auch die Anwendung von anhydridhaltigen Polymeren in Resists (siehe EP--A-0 388 484, EP-A-0 394 740, EP-A-0 394 741 und EP-A-0 395 917). Aus der DE-OS 1 495 850 ist ein Verfahren zur Herstellung von Maleinsäureanhydrid-Copolymerisaten durch gleichzeitige Zugabe einer Copolymerisationskomponente, d.h. einer Vinylverbindung, und eines Radikalbildners bzw. deren Lösungen zu vorgelegtem Maleinsäureanhydrid oder dessen Lösung bekannt. Dabei beträgt das molare Verhältnis des insgesamt eingesetzten Maleinsäureanhydrids zur Copolymerisationskomponente 1:0,05 bis 1:0,7 und die Gesamtmenge an Radikalbildner 1 bis 15 Mol-%, bezogen auf das Gesamtgewicht der Polymerisationskomponenten. Als mit Maleinsäureanhydrid copolymerisierbare Vinylmonomere eignen sich unter anderem (Meth)acrylsäure und deren Ester, wie Methylmethacrylat sowie Ethyl- und Butylacrylat. Die erhaltenen Maleinsäureanhydrid-Copolymerisate sind im wesentlichen nicht-alternierend aufgebaut.

Aufgabe der Erfindung ist es, neue definierte Mischpolymere bereitzustellen.

Dies wird erfindungsgemäß durch Mischpolymere erreicht, die aus 40 bis 99 Mol-% eines tert.-Butylesters einer ungesättigten Carbonsäure (Komponente A) und 1 bis 60 Mol.-% eines Anhydrids einer ungesättigten Carbonsäure (Komponente B) aufgebaut sind. Die Komponenten A und B ergänzen sich dabei jeweils zu 100 %.

Durch die Erfindung werden definierte Mischpolymere (auf der Basis von Carbonsäure-tert.-butylestern und Carbonsäureanhydriden) bereitgestellt, d.h. Polymere, bei denen Art und Anteil der Grundbausteine durch die Monomermischung bestimmt werden; derartige Polymere sind bislang nicht bekannt. Bekannt sind lediglich undefinierte Terpolymere aus tert.-Butylmethacrylat, Methacrylsäure und Methacrylsäureanhydrid, die beim Erhitzen von tert.-Butylmethacrylat-Homopolymeren nach einer UV-Belichtung in Gegenwart eines Sulfoniumsalzes entstehen (siehe dazu: "Macromolecules", Vol. 21 (1988), Seiten 1475 bis 1482).

Bei den Mischpolymeren nach der Erfindung ist die Komponente A vorzugsweise Acrylsäure-tert.-butylester, Methacrylsäure-tert.-butylester oder Vinylbenzoesäure-tert.-butylester. Daneben kommen als polymerisierbare Monomere beispielsweise die tert.-Butylester von Maleinsäure, Fumarsäure und Zimtsäure in Betracht. Die Komponente B ist vorzugsweise Maleinsäureanhydrid. Ein anderes polymerisierbares Monomer ist beispielsweise Itaconsäureanhydrid.

Die Mischpolymere nach der Erfindung können nicht nur als Bipolymere (der vorstehend genannten Art), sondern auch als Terpolymere aufgebaut sein; in derartige Polymere ist erfindungsgemäß zusätzlich eine ungesättigte aromatische Verbindung (Komponente C) eingebaut, d.h. eine aromatische Verbindung mit einem olefinisch ungesättigten Substituenten. Als Komponente C dient dabei vorzugsweise Styrol, α-Methylstyrol oder Vinylnaphthalin. Allgemein kommen als Komponente C polymerisierbare aromatische Verbindungen, auch solche mit polycyclischem oder heterocyclischem Aufbau, in Betracht, insbesondere substituierte Styrole und Vinylnaphthaline. Durch den Einbau eines dritten Monomerbausteins können bestimmte Eigenschaften der Polymere verbessert werden, beispielsweise die Plasmaätzresistenz.

Die erfindungsgemäßen Mischpolymere werden in der Weise hergestellt, daß ein tert.-Butylester einer ungesättigten Carbonsäure, zusammen mit einem Radikalinitiator und gegebenenfalls einer ungesättigten aromatischen Verbindung der genannten Art, langsam zu einer auf erhöhter Temperatur befindlichen Lösung eines Anhydrids einer ungesättigten Carbonsäure in einem organischen Lösungsmittel gegeben wird. Vorteilhaft wird dabei der polymerisationsfähige tert.-Butylester mit dem Initiator, der vorzugsweise Azoisobuttersäurenitril ist, zu einer siedenden Anhydridlösung getropft; als Lösungsmittel dient beispielsweise Toluol oder Ethylacetat. Auf diese Weise wird ein hoher Anteil an Anhydrid in das Mischpolymere eingebaut.

Die Mischpolymere nach der Erfindung können vorteilhaft als Basispolymere für hochauflösende, positiv oder negativ arbeitende Resists eingesetzt werden; siehe dazu die deutsche Patentanmeldung Akt.Z. P 40 41 001.3 (GR 90 P 8601 DE) - "Photoresist" (EP-A-494383). Derartige Resists zeigen insbesondere im DUV-Bereich (Deep UV) eine hohe Empfindlichkeit. Die in den Mischpolymeren vorhandenen Anhydridfunktionen führen - nach Belichtung bzw. Belichtung und Entwicklung durch Reaktion mit geeigneten Substanzen - zu einer deutlichen Erhöhung der Ätzresistenz. Im Vergleich zu den Resistsystemen nach der EP--A-0 102 450, die Homopolymere von tert.-Butylestern enthalten, bieten Resists mit Polymeren nach der Erfindung den Vorteil, daß sie Anhydridfunktionen aufweisen, welche in Lösung lagerstabil sind und eine in-situ-Modifizierung zum Zweck der Erhöhung der Ätzresistenz ermöglichen.

Auch wenn die erfindungsgemäßen Mischpolymere einen hohen Anhydridanteil - und entsprechend einen geringeren Esteranteil - aufweisen, leidet darunter die Empfindlichkeit von diese Polymere enthaltenden Resists nicht. Außerdem wird mit derartigen Resists nach einer in-situ-Reaktion mit einem Silylierungsreagenz, insbesondere einem Aminoalkylsiloxan, eine - im Vergleich zu anderen Systemen - deutlich höhere Ätzresistenz gegen Sauerstoffplasmen erreicht. Aus diesem Grund können diese Resists bei Trockenentwicklungs-Resisttechniken Verwendung finden, wo sehr scharfe Entwicklungsbedingungen angewendet werden. Dies gilt insbesondere für Zweistufen-Ätzprozesse, bei denen in der ersten Stufe mit einem halogenhaltigen Plasma und in der zweiten Stufe mit einem reinen Sauerstoffplasma geätzt wird, um den Bottomresist vollständig zu entfernen. Im übrigen zeigen die Polymere nach der Erfindung überraschenderweise deutlich höhere Ätz- und Dosistoleranzen als vergleichbare Systeme (siehe dazu beispielsweise EP--A-0 395 917). Die Mischpolymere nach der Erfindung werden deshalb bei der Erzeugung von Strukturen im Submikron-Bereich eingesetzt; siehe dazu die deutsche Patentanmeldung Akt.Z. P 40 41 002.1 (GR 90 P 8602 DE) - "Photolithographische Strukturerzeugung" (EP-A-492256).

Anhand von Ausführungsbeispielen soll die Erfindung noch näher erläutert werden.

### Beispiel 1

12,75 g Maleinsäureanhydrid (0,13 mol) werden in 77 ml siedendem Toluol gelöst. Zu dieser Lösung werden 14,22 g frisch destillierter Methacrylsäure-tert.-butylester (0,1 mol), in welchem 0,188 g Azoisobuttersäurenitril (0,00115 mol) gelöst sind, langsam zugetropft; die Toluollösung bleibt dabei stets am Sieden. Nach Beendigung der Zugabe (ca. 15 min) wird die Lösung weitere 60 min unter Rückfluß gekocht, dann läßt man auf Raumtemperatur abkühlen. Das durch Ausfällen mit ca. 1,5 l Isopropanol erhaltene feinflockige Produkt wird abfiltriert, dreimal mit Isopropanol gewaschen und im Vakuumschrank bis zur Gewichtskonstanz getrocknet; es werden 18 g weißes Pulver erhalten. Das Infrarotspektrum zeigt eindeutig die Existenz des erwarteten Copolymers aus Methacrylsäure-tert.-butylester und Maleinsäureanhydrid; thermische Spaltung (TGA, Peakmaximum): 163°C; Anhydridanteil (TGA): 50 Mol-%.

### Beispiel 2

12,75 g Maleinsäureanhydrid (0,13 mol) werden in 50 ml siedendem Ethylacetat gelöst. Zu dieser Lösung wird eine Mischung aus 14,22 g frisch destilliertem Methacrylsäure-tert.-butylester (0,1 mol) und 27 ml Ethylacetat, in der 0,188 g Azoisobuttersäurenitril (0,00115 mol) gelöst sind, langsam zugetropft; die Ethylacetatlösung bleibt dabei stets am Sieden. Nach Beendigung der Zugabe (ca. 15 min) wird die Lösung weitere 60 min unter Rückfluß gekocht, dann läßt man auf Raumtemperatur abkühlen. Das durch Ausfällen mit ca. 1,5 l Isopropanol erhaltene grobflockige Produkt wird abfiltriert, dreimal mit Isopropanol gewaschen und im Vakuumschrank bis zur Gewichtskonstanz getrocknet; es werden 18,4 g leicht gelbliches Pulver erhalten. Durch Lösen dieses Produktes in 2-Butanon und Umfällen in Isopropanol wird ein weißes Pulver erhalten. Das Infrarotspektrum zeigt eindeutig die Existenz des erwarteten Copolymers aus Methacrylsäure-tert.-butylester und Maleinsäureanhydrid; thermische Spaltung (TGA, Peakmaximum): 169°C; Anhydridanteil (TGA): 50 Mol-%.

### Beispiel 3

32,36 g Maleinsäureanhydrid (0,33 mol) werden in 210 ml siedendem Toluol gelöst. Zu dieser Lösung werden 38,45 g frisch destillierter Acrylsäure-tert.-butylester (0,3 mol), in welchem 0,517 g Azoisobuttersäurenitril (0,00315 mol) gelöst sind, langsam zugetropft; die Toluollösung bleibt dabei stets am Sieden. Nach Beendigung der Zugabe (ca. 15 min) wird die Lösung weitere 60 min unter Rückfluß gekocht, dann läßt man auf Raumtemperatur abkühlen. Das durch Ausfällen mit ca. 1,5 l Isopropanol erhaltene feinflockige Produkt wird abfiltriert, dreimal mit Isopropanol gewaschen und im Vakuumschrank bis zur Gewichtskonstanz getrocknet; es werden 44,4 g weißes Pulver erhalten. Das Infrarotspektrum zeigt eindeutig die Existenz des erwarteten Copolymers aus Acrylsäure-tert.-butylester und Maleinsäureanhydrid; thermische Spaltung (TGA, Peakmaximum): 152°C; Anhydridanteil (TGA): 50 Mol-%.

### Beispiel 4

Ein Resist, bestehend aus 23,75 Masseteilen eines entsprechend Beispiel 1 hergestellten Methacrylsäure-tert.-butylester/Maleinsäureanhydrid-Copolymers, 1,25 Masseteilen Triphenylsulfonium-trifluormethansulfonat und 75 Masseteilen Methoxypropylacetat, wird auf einen Siliciumwafer aufgeschleudert (3000 rpm, 20 s), dann wird 60 s bei 90°C getrocknet; die Schichtdicke des dabei resultierenden Films beträgt ca. 1 µm. Der Film wird für 400 s mit einer Lösung aus 2 Masseteilen Diaminosiloxan (Tegomer A-Si 2120; Fa. Goldschmidt), 45 Masseteilen Ethanol und 53 Masseteilen Isopropanol behandelt, 30 s mit Isopropanol gespült und dann getrocknet; die Schichtdicke des Films beträgt nunmehr 1,4 µm. Anschließend wird der Wafer in eine Plasmaätzanlage (Material Research Corporation, Typ MIE 720) gebracht und 300 s im Sauerstoffplasma trocken geätzt (O₂/RIE: 1,9 mTorr Gasdruck, 40 V Biasspannung, 0,9 kW Leistung, mit Magnet); nach der Ätzung beträgt die Schichtdicke 1,19 µm. Hieraus errechnet sich eine Abtragsrate der silylierten Schicht von 0,7 nm/s.

## Patentansprüche

1. Mischpolymere, **dadurch gekennzeichnet**, daß sie aus 40 bis 99 Mol-% eines tert.-Butylesters einer ungesättigten Carbonsäure (Komponente A) und 1 bis 60 Mol-% eines Anhydrids einer ungesättigten Carbonsäure (Komponente B) aufgebaut sind.

2. Mischpolymere nach Anspruch 1, **dadurch gekennzeichnet,** daß die Komponente A Acrylsäure-tert.-butylester, Methacrylsäure-tert.-butylester oder Vinylbenzoesäure-tert.-butylester ist.

3. Mischpolymere nach Anspruch 1 oder 2, **dadurch gekennzeichnet,** daß die Komponente B Maleinsäureanhydrid ist.

4. Mischpolymere nach einem der Ansprüche 1 bis 3, **dadurch gekennzeichnet,** daß zusätzlich eine ungesättigte aromatische Verbindung (Komponente C) eingebaut ist.

5. Mischpolymere nach Anspruch 4, **dadurch gekennzeichnet,** daß die Komponente C Styrol, α-Methylstyrol oder Vinylnaphthalin ist.

6. Verfahren zur Herstellung von Mischpolymeren nach einem oder mehreren der Ansprüche 1 bis 5, **dadurch gekennzeichnet**, daß ein tert.-Butylester einer ungesättigten Carbonsäure, zusammen mit einem Radikalinitiator und gegebenenfalls einer ungesättigten aromatischen Verbindung, langsam zu einer auf erhöhter Temperatur befindlichen Lösung eines Anhydrids einer ungesättigten Carbonsäure in einem organischen Lösungsmittel gegeben wird.

7. Verfahren nach Anspruch 6, **dadurch gekennzeichnet,** daß als Radikalinitiator Azoisobuttersäurenitril verwendet wird.

## Claims

1. Mixed polymers, characterized in that they are structured from 40 to 99 mole % of a tert. butyl ester of an unsaturated carboxylic acid (component A) and 1 to 60 mole % of an anhydride of an unsaturated carboxylic acid (component B).

2. Mixed polymers according to claim 1, characterized in that component A is acrylic acid tert. butyl ester, methacrylic acid tert. butyl ester or vinyl benzoic acid tert. butyl ester.

3. Mixed polymers according to claim 1 or 2, characterized in that component B is maleic anhydride.

4. Mixed polymers according to one of claims 1 to 3, characterized in that an unsaturated aromatic compound (component C) is additionally built in.

5. Mixed polymers according to claim 4, characterized in that component C is styrene, α-methyl styrene or vinyl naphthalene.

6. Method for producing mixed polymers according to one or more of claims 1 to 5, characterized in that a tert. butyl ester of an unsaturated carboxylic acid, together with a radical initiator and possibly an unsaturated aromatic compound, is slowly added to a solution of an anhydride of an unsaturated carboxylic acid in an organic solvent, which solution is at a raised temperature.

7. Method according to claim 6, characterized in that azoisobutyric acid nitrile is used as radical initiator.

## Revendications

1. Copolymères caractérisés en ce qu'ils sont constitués par 40 à 99 moles % d'un ester tert.-butylique d'un acide carboxylique insaturé (composant A) et de 1 à 60 moles % d'un anhydride d'un acide carboxylique insaturé (composant B).

2. Copolymères selon la revendication 1, caractérisés en ce que le composant A est l'ester tert.-butylique d'acide acrylique et l'ester tert.-butylique d'acide méthacrylique ou encore l'ester tert.-butylique de l'acide vinylbenzoïque.

3. Copolymères selon la revendication 1 ou 2, caractérisés en ce que le composant B est l'anhydride maléique.

4. Copolymères selon l'une quelconque des revendications 1 à 3, caractérisés en ce qu'on incorpore, en outre, un composé aromatique insaturé (composant C).

5. Copolymères selon la revendication 4, caractérisés en ce que le composant C est le styrène, l'α-méthylstyrène ou le vinylnaphtalène.

6. Procédé pour la préparation de copolymères selon l'une ou plusieurs des revendications 1 à 5, caractérisé en ce qu'on ajoute lentement un ester tert.-butylique d'un acide carboxylique insaturé, conjointement avec un initiateur radicalaire et éventuellement un composé aromatique insaturé, à une solution se trouvant à température élevée d'un anhydride d'un acide carboxylique insaturé dans un solvant organique.

7. Procédé selon la revendication 6, caractérisé en ce que, comme initiateur radicalaire, on utilise le nitrile de l'acide azoisobutyrique.
